# EUROPEAN PATENT SPECIFICATION

(11) **EP 0 390 209 B1**
(45) Date of publication and mention of the grant of the patent: **25.08.1993**
(21) Application number: 90106184.6
(22) Date of filing: 30.03.1990
(51) Int. Cl.: H01L 33/00

(54) **Diamond light-emitting device**
Lichtemittierende Diamantanordnung
Dispositif émetteur de lumière en diamant

(30) Priority: 30.03.1989 JP 80980/89
(43) Date of publication of application: 03.10.1990
(73) Proprietor: SUMITOMO ELECTRIC INDUSTRIES, LTD., Osaka-shi, Osaka 541 (JP)
(72) Inventor: Fujimori, Naoji, c/o Itami Works, Itami-shi, Hyogo (JP); Nishibayashi, Yoshiki, c/o Itami Works, Itami-shi, Hyogo (JP); Shiomi, Hiromu, c/o Itami Works, Itami-shi, Hyogo (JP)
(74) Representative: Grünecker, Kinkeldey, Stockmair & Schwanhäusser Anwaltssozietät

(56) References cited:
- SOVIET PHYSICS SEMICONDUCTORS. vol. 19, no. 8, August 1985, NEW YORK US pages 829 - 841; BAZHENOV ET AL.: "SYNTHETIC DIAMONDS IN ELECTRONICS (REVIEW)"
- PATENT ABSTRACTS OF JAPAN vol. 13, no. 584 (E-866)(3932) 22 December 1989, & JP-A-1 246867 (SUMITOMO ELECTRIC INDUSTRIES LTD) 02 October 1989.

## Description

### BACKGROUND OF THE INVENTION

The present invention relates to a light-emitting device that emits light in the visible range upon application of voltage. More particularly, the present invention relates to a light-emitting device that uses diamond.

The light-emitting diode is a device that emits light with high efficiency even at low voltage and is used extensively as a display device. The light-emitting diode makes use of spontaneous emission of light from a semiconductor. Most specifically, excess energy that is generated by recombination of excess carriers at the p-n junction plane of a semiconductor is converted to light. Light-emitting diodes known today are capable of emitting light at various wave-lengths ranging from the blue to infrared region.

Semiconductors typically used in light-emitting diodes include III-V compounds such as GaAs, GaP, GaAsP and InP, II-VI compounds such as ZnSe and CdS, and SiC.

Compared to these semiconductor materials, diamond has a much greater band gap (5.47 eV). Thus, light-emitting devices using diamond have the potential to emit light in the shorter wavelength range such as blue or ultraviolet light.

As already mentioned, a p-n junction is commonly used as a means of injecting carriers for light emission. A diamond having a p-type conduction characteristic can be easily formed by doping with boron (B). However, although the formation of a diamond having an n-type conduction characteristic has been reported, the resistance thereof is very high. Hence, light-emitting devices using diamond are incapable of producing desired light emission unless carrier injection is accomplished by means other than a p-n junction. Theoretically, a point contact satisfies this requirement but it is not suitable for use in actual devices.

A Schottky junction has been reported as a means of providing a rectifying effect for diamond. Collins et al. reported that gold formed an effective Schottky junction for diamond (J. Phys. D. Appl. Phys., 9, 951 (1976)). Geis et al. reported that tungsten also formed an effective Schottky junction for diamond (IEEE, Electron Device Letters, EDL, 8, 341 (1987)).

A part of the present inventors reported in Japanese Patent Application No. 63-75177 that tungsten was a metal capable of forming a Schottky junction to a boron-doped epitaxial layer that was grown on a single-crystal diamond substrate.

With this state of the art taken into consideration, the present inventors surmised that a light-emitting device could be formed of diamond if carrier injection was performed by means of a Schottky junction formed between the diamond and one of the metals described above.

### SUMMARY OF THE INVENTION

An object, therefore, of the present invention is to provide a light-emitting device made of diamond that uses a Schottky junction as a means of carrier injection.

The light-emitting device of the present invention comprises a substrate of single-crystal diamond, a boron-doped epitaxial layer of diamond that is grown on the principal surface of the substrate by a vapor-phase synthesis technique, and a positive ohmic and a negative Schottky electrode which are formed on the epitaxial layer, in which the negative electrode is made of a metal selected from the group consisting of tungsten, molybdenum, gold and a aluminum.

### BRIEF DESCRIPTION OF THE DRAWINGS

Fig. 1 is a perspective view showing the construction of the light-emitting device in accordance with an embodiment of the present invention;
Fig. 2 is a graph showing the voltage vs. current characteristic of the light-emitting device of Fig. 1; and
Fig. 3 is a graph showing the emission spectrum of the light-emitting device of Fig. 1.

### DETAILED DESCRIPTION OF THE INVENTION

In order to fabricate a light-emitting device from diamond that is capable of light emission in a highly reproducible manner, it is necessary that the diamond which largely affects operating characteristics be of a good quality and have highly reproducible characteristics. Further, a low-resistance region must be formed since it is necessary to provide a current conducting path in the diamond. In other words, a boron-doped diamond is necessary.

Catalyst metals, nitrogen and other impurities are prone to contaminate the diamond being synthesized by ultrahigh-pressure methods, so it is difficult to obtain a stable B-doped diamond. On the other hand, a B-doped diamond having stable characteristics can be obtained by allowing a boron-doped epitaxial layer to grow on the principal surface of a substrate of single-crystal diamond by a vapor-phase synthesis technique. If single-crystal diamond is not used as a substrate, the growing layer will be comprised of polycrystalline diamond and have labile characteristics.

If a boron-doped epitaxial layer is grown on a diamond prepared by ultrahigh-pressure methods, a B-doped diamond layer can be formed that is of high purity including no impurities other than boron and that has stable characteristics.

In accordance with the present invention, a positive and a negative electrode are formed on the thus grown epitaxial layer. The negative electrode shows good Schottky characteristics if it is made of a metal selected from the group consisting of tungsten, molybdenum, gold and aluminum. The positive electrode is made of a metal that provides an ohmic junction with diamond. For example, titanium is used as the material of positive electrode.

The voltage vs. current characteristic established between the positive and negative electrodes is of a rectifying nature.

The light-emitting device of the preset invention emits light containing shorter wavelength components ranging from blue to green light, so it can be used as a blue light-emitting device in combination with an appropriate filter. This light-emitting device is useful in many applications such as display devices and LED televisions.

In forming a boron-doped epitaxial layer of diamond, it is important to use a method capable of producing high-purity films. Preferably, electrode-less plasma-assisted CVD techniques such as microwave plasma-assisted CVD and RF plasma-assisted CVD techniques are used. Doping with boron is typically performed by supplying a feedstock in gaseous form but this is not the sole method that can be used and other methods may of course be employed.

The single-crystal diamond which is to be used as the substrate for the growth of epitaxial layer is preferably a diamond of Ib or IIa type rather than a diamond of Ia type. Equally good results are attained irrespective of whether the diamond is naturally occurring or synthesized artificially.

In order to accomplish the growth of an epitaxial layer having stable characteristics, the principal surface of the single-crystal diamond substrate preferably has Miller indices (100). However, the Miller indices of the principal surface are by no means limited to (100).

The positive and negative electrodes are preferably formed on the epitaxial layer by vapor-phase synthesis techniques such as vacuum evaporation, sputtering and CVD methods. These vapor-phase synthesis techniques have the advantage that an effective junction can be formed without introducing any unwanted impurities at the interface between either electrode and the epitaxial layer. Other methods may of course be used to form the positive and negative electrodes.

Titanium exhibits good characteristics for use as a material for the positive electrode which provides an ohmic junction with diamond, but other metals may of course be used as long as they exhibit similar characteristics.

### Example 1

Synthetic single-crystal diamond was cut, ground and polished to form a substrate of a size of 2 x 2 x 0.5 mm. The principal surface of this substrate had Miller indices (100) and a surface roughness of about 20 nm (200 Å).

Using a mixture of 1% CH₄, 0.00005% B₂H₆ and bal. H₂ as a reactive gas, a B-doped layer was formed on the principal surface of the substrate by a known microwave plasma-assisted CVD method. The process conditions were 40 Torr and 900°C (substrate temperature). The B-doped layer had a thickness of 0.5 µm.

The B-doped layer was found to be comprised of single-crystal diamond by reflection high-energy electron diffraction. It was therefore concluded that this layer had grown epitaxially.

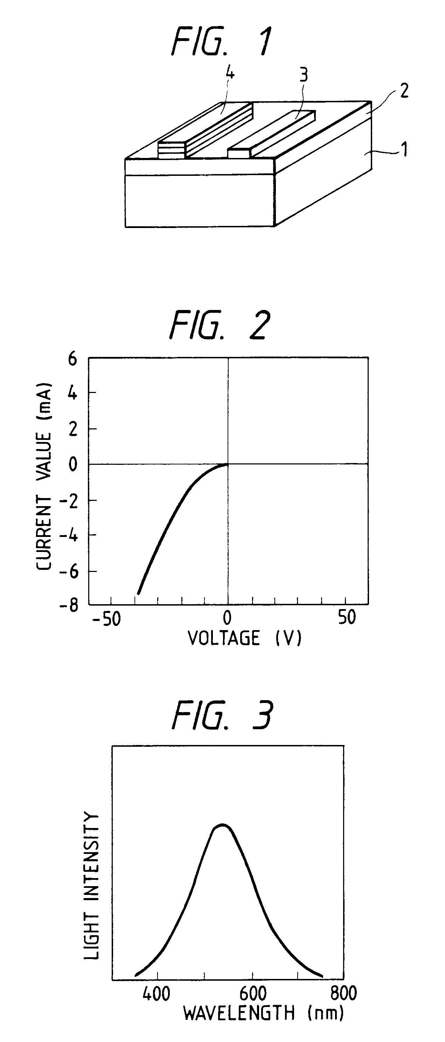

The electrodes were formed on the B-doped epitaxial layer using a metal mask. The two electrodes formed on the epitaxial layer are shown schematically in Fig. 1. As shown, the B-doped epitaxial layer 2 was formed over the principal surface of the single-crystal diamond substrate 1, and the negative electrode 3 and the positive electrode 4 were formed on the epitaxial layer 2.

The negative electrode 3 was a tungsten electrode that was formed with a planar sputtering apparatus in an argon (Ar) atmosphere at 10⁻² Torr. The positive electrode 4 was composed of three layers of titanium, molybdenum and gold. The bottommost layer in contact with the B-doped epitaxial layer 2 was made of titanium, the intermediate layer was made of molybdenum, and the topmost layer was made of gold. The three-layered electrode 4 was formed by vacuum evaporation at a pressure of 10⁻⁵ Torr.

The titanium layer had a thickness of 0.5 µm, the molybdenum layer, 0.8 µm, and the gold layer, 0.5 µm. The tungsten electrode 3 had a thickness of 0.5 µm.

The voltage vs. current characteristics established between the positive electrode 4 and the negative electrode 3 were found to be of a rectifying nature as shown in Fig. 2.

When a dc voltage of -40 volts was applied between the tungsten negative electrode 3 and the three-layered positive electrode 4 by means of a tungsten probe, light emission was observed around the tungsten electrode 3. The result of spectroscopy performed on this light emission is shown in Fig. 3. The spectrum had a peak at 530 nm.

### Example 2

A native diamond of IIa type was cut, ground and polished to make a substrate of a size of 1.5 x 1.5 x 0.3 mm. The principal surface of the substrate had Miller indices (100).

A boron-doped layer of diamond was grown epitaxially on the principal surface of the substrate under the same conditions as in Example 1. A tungsten film was formed on the epitaxial layer by a CVD technique involving the decomposition of WF₆. Thereafter, a tungsten electrode of a predetermined shape was made by photolithographic procedures consisting of exposure with a resist pattern used as a mask and development (etching) with aqua regia. Further, a three layered (Ti-Mo-Au) electrode was formed by vacuum evaporation.

A dc voltage of -50 volts was applied to the thus fabricated device, with the tungsten electrode working as a negative electrode. The device emitted light having a spectrum with a peak at 470 nm.

### Example 3

A boron-doped epitaxial layer was formed on a substrate that was the same as that was used in Example 1. The method of epitaxial growth was also the same as what was employed in Example 1. A gold layer was deposited in a thickness of 0.5 µm on the epitaxial layer by vacuum evaporation at 10⁻⁵ Torr to form a Schottky electrode that was to serve as a negative electrode. An additional sample was prepared under the same process conditions except that a molybdenum layer was deposited in place of the gold layer. Still another sample was prepared under the same process conditions except that an aluminum layer was deposited in place of the gold layer.

An ohmic electrode which was to serve as a positive electrode was formed on each of the three samples as in Example 1.

When a dc voltage of -50 volts was applied to the sample using the gold negative electrode, it emitted light having a spectral peak at 520 nm. When a dc voltage of -40 volts was applied to the sample using the molybdenum negative electrode, it emitted light having a spectral peak at 530 nm. When a dc voltage of -55 volts was applied to the sample using the aluminum negative electrode, it emitted light having a spectral peak at 470 nm.

## Claims

1. A light-emitting device, comprising:
a substrate of single-crystal diamond;
a boron-doped epitaxial layer of diamond that is grown on a principal surface of said substrate by a vapor-phase synthesis technique; and
a positive ohmic- and a negative Schottky- electrode which are formed on said epitaxial layer, said negative electrode being made of a metal selected from the group consisting of tungsten, molybdenum, gold and aluminum.

2. A light-emitting device as claimed in claim 1, wherein said positive electrode is made of titanium.

3. A light-emitting device as claimed in claim 1, wherein said single-crystal diamond is a diamond of Ib or IIa type.

4. A light-emitting device as claimed in claim 1, wherein said principal surface of said substrate has Miller indices (100).

## Patentansprüche

1. Eine Licht emittierende Vorrichtung mit einem Substrat aus einkristallinem Diamant;
einer Bor dotierten epitaktischen Diamantschicht, die auf einer Hauptoberfläche des Substrats durch Gasphasen-Syntheseverfahren gewachsen wird; und
mit einer positiven ohmschen und einer negativen Schottky-Elektrode, die auf der epitaktischen Schicht ausgebildet sind, wobei die negative Elektrode aus einem Metall aus der Gruppe ist, die Wolfram, Molybden, Gold und Aluminium umfaßt.

2. Eine Licht emittierende Vorrichtung nach Anspruch 1, wobei die positive Elektrode aus Titan hergestellt ist.

3. Eine Licht emittierende Vorrichtung nach Anspruch 1, wobei der einkristalline Diamant ein Diamant eines Ib- oder IIa-Typs ist.

4. Eine Licht emittierende Vorrichtung nach Anspruch 1, wobei die Hauptoberfläche des Substrats die Miller-Indizes (100) hat.

## Revendications

1. Dispositif émetteur de lumière comprenant :
un substrat en diamant monocristallin ;
une couche en diamant épitaxiale dopée au bore qui est obtenue par croissance sur une surface principale dudit substrat au moyen d'une technique de synthèse en phase vapeur ; et
une électrode ohmique positive et une électrode Schottky négative qui sont formées sur ladite couche épitaxiale, ladite électrode négative étant réalisée en un métal choisi parmi le groupe comprenant le tungstène, le molybdène, l'or et l'aluminium.

2. Dispositif émetteur de lumière selon la revendication 1, dans lequel ladite électrode positive est réalisée en titane.

3. Dispositif émetteur de lumière selon la revendication 1, dans lequel ledit diamant monocristallin est un diamant du type Ib ou du type IIa.

4. Dispositif émetteur de lumière selon la revendication 1, dans lequel ladite surface principale dudit substrat présente des indices de Miller (100).
